Europäisches Patentamt

European Patent Office

Office européen des brevets

(11) Publication number: **0 064 231**
**B1**

# EUROPEAN PATENT SPECIFICATION

(45) Date of publication of patent specification: **13.01.88**

(51) Int. Cl.⁴: **H 01 L 23/48,** H 01 L 21/60

(21) Application number: **82103413.9**

(22) Date of filing: **22.04.82**

(54) **Compression-type semiconductor device.**

(30) Priority: **30.04.81 JP 65956/81**

(43) Date of publication of application:
**10.11.82 Bulletin 82/45**

(45) Publication of the grant of the patent:
**13.01.88 Bulletin 88/02**

(84) Designated Contracting States:
**CH DE GB LI SE**

(56) References cited:
**DE-A-2 757 821**
**DE-A-3 009 511**
**FR-A-2 077 332**
**US-A-4 161 740**

(73) Proprietor: **Kabushiki Kaisha Toshiba**
**72, Horikawa-cho Saiwai-ku**
**Kawasaki-shi Kanagawa-ken 210 (JP)**

(72) Inventor: **Azuma, Makoto**
**205 Nakakibogaoka**
**Asahi-ku Yokohama-shi (JP)**

(74) Representative: **Henkel, Feiler, Hänzel & Partner**
**Möhlstrasse 37**
**D-8000 München 80 (DE)**

Courier Press, Leamington Spa, England.

## Description

This invention relates to a semiconductor element in particular to a compression-type semiconductor device in which such semiconductor elements as transistors and gate turn-off thyristors are maintained in a compressed state and, more particularly, to large current compression-type semiconductor devices.

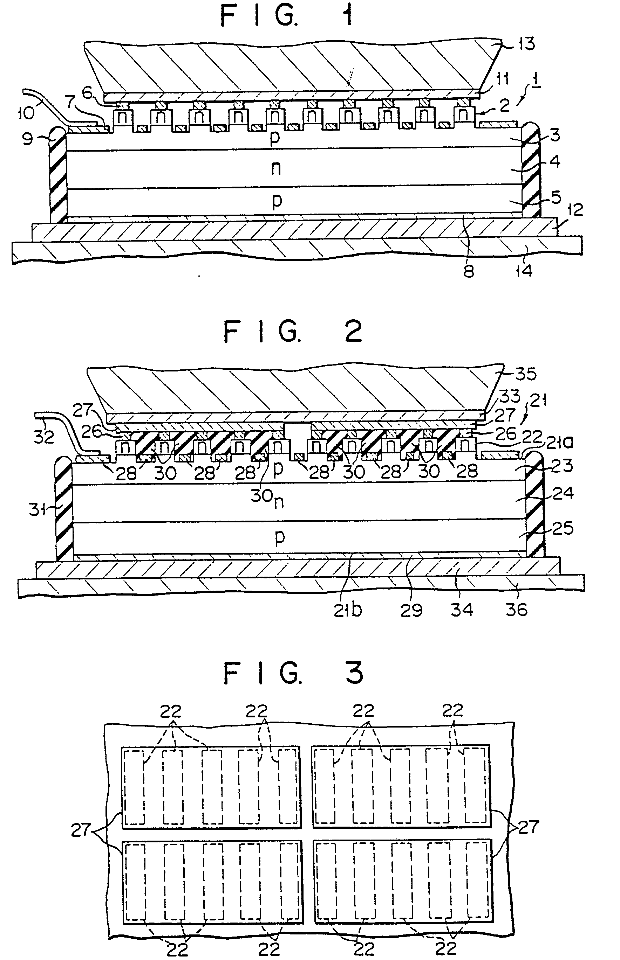

Compression-type semiconductor devices having such semiconductor elements as transistors and gate turn-off (GTO) thyristors which are maintained in compressed states are well known as large current devices which can carry currents in excess of 100 A. Fig. 1 shows a prior art compression-type GTO thyristor device. The device has a GTO thyristor element including a substrate 1. The substrate 1 has an n-type cathode region 2 which is divided into a plurality of mesa portions and exposed at the top surface thereof, a first base region (gate region) 3 of p-type surrounding the region 2, a second base region 4 of n-type which is in contact with the region 3 and an anode region 5 of p-type which is in contact with the region 4 and exposed at the bottom surface thereof. Separate cathode electrodes 6 are formed on the surface of each mesa portion of the cathode region 2, and a gate electrode 7 is formed on the exposed surface of the gate region 3. An anode electrode 8 is formed on the entire exposed surface of the anode region 5 (i.e., the bottom surface of the substrate 1). The peripheral side surfaces of the substrate 1 are covered by an insulating layer 9.

A metal plate 11 covers the cathode electrodes 6, and a cylindrical metal post 13 presses the metal plate 11 against the cathode electrodes 6. A metal plate 12 is bonded to the anode electrode 8 at one surface thereof, and is supported by a metal post 14 at the other surface thereof. A metal wire 10 is bonded to the gate electrode 7 at one end, and is connected to a gate terminal of an envelope (not shown) at the other end thereof.

The GTO thyristor element is considered to consist of a plurality of GTO thyristor units, or npnp 4-layer semiconductor regions which lie underneath the cathode electrodes 6, respectively. The GTO thyristor units are regarded as being connected parallel to one another, because the cathode electrodes 6 are electrically connected to the metal plate 11 and the anode electrode 8 functions as a common electrode for anode regions of the units (although each gate region, base region, and anode region of each thyristor unit is connected with one another, the thyristor units are considered as substantially independent from one another since the connections are made with very high resistivities of the regions 3, 4 and 5, respectively). In order to most efficiently operate such a GTO thyristor element, it is desired that each thyristor unit has excellent characteristics and that the characteristics are uniform and without fluctuations among the individual thyristor units. From the manufacturing point of view, it is further desired that a thyristor unit or units of defective characteristics, if present, can readily be detected.

To turn the GTO thyristor from a conductive state to a non-conductive state, a negative voltage pulse is supplied to the gates to cause a negative current pulse to pass through the gate-cathode path, thus cutting the main current. The inventor has observed this turn-off process with an infrared microscope in detail and found that at an initial stage of the turn-off process, substantially uniform current flows in all the cathode mesa regions, but in an advanced stage of the turn-off process, the current tends to concentrate on a portion of each cathode mesa region at the maximum distance from the gate electrode, i.e., on a central portion in the case of mesa cathode having a rectangular surface. When the current density is highly increased in this way, the GTO thyristor or its units can no longer be turned off, and the GTO thyristor is permanently destroyed due to power loss. The inventor has contemplated reducing the distance between the gate and cathode in order to increase the maximum operational (or controllable) current $I_{ATO}$. If the gate-cathode distance is reduced, the resistance of the base region would also be reduced so that the gate current would flow more readily, facilitating the turn-off and thus increasing $I_{ATO}$. In addition, by reducing the gate-cathode distance, the volume of the unit gate region or element unit is reduced, thus minimizing excess carriers to be drained from the gate. By doing so, it may be possible to provide a device which has a reduced turn-off time and is thus suitable as a switching element.

The present inventor has measured the $I_{ATO}$ and turn-off time with respect to two GTO thyristor units. One of the units had a mesa cathode with a rectangular top surface 4 mm long and 200 μm wide. The other unit has a mesa cathode with a rectangular surface 4 mm long and 1 mm wide. It has been found that the former unit had a $I_{ATO}$ 2 times higher than that of the latter unit and a turn-off time 1/3 of that of the latter unit.

However, for the operation of the GTO thyristor element it is necessary to maintain a certain constant current density in the conductive state of the element as a whole. Where the cathode width is reduced with the same cathode length as in the case above, the area of the element unit is reduced. In this case, therefore, it is necessary to increase the number of units in order to maintain a current density at the certain level. If the number of units in the prior art GTO element as shown in Fig. 1 is increased, the number of defective element units per element may be increased, and the time required for the detection and removal of the defective element units is also increased. Even a single defective element unit in the element will seriously affect the characteristics of the element as a whole, because all the units of the element are operated in parallel. The simplest example of the defect is the short-circuit between the cathode and gate of the unit. Even if such a single defective unit is present, the cathode-gate of the whole element is short-circuited, and the element cannot be operated. The usual method of finding a defective element unit is to measure the characteristics of all the units one after another with a probe, and a well-known method of repair is to remove the electrodes of the defective element unit. However, when manufacturing the GTO element of the conventional construction, it is troublesome to detect defective units by using the method mentioned above. For example, where the GTO element of the prior art construction is manufactured by arranging flat rectangular GTO units having mesa cathode regions with a length of 600 μ and a width of 150 in a pellet with a diameter of 50 mm, the number of GTO thyristor units included is as large as about 8,000. If defective units are detected by the aforementioned method, enormous time is required. This has been a serious drawback in the mass production of devices. This drawback also applies to the manufacture of large current transistors having a divided emitter construction.

Prior art document FR—A—2,077,332 discloses a semiconductor power device formed of a semiconductor element comprising a semiconductor substrate having first and second major surfaces. On one major surface there is provided a first semiconductor region including a plurality of semiconductor sections, said sections each being composed of a plurality of semiconductor segments of a first conductivity type. These segments are arranged so that long sides of adjacent segments face each other. A second semiconductor region of a second conductivity type opposite to said first conductivity type is formed in the first major surface and surrounds each of said semiconductor segments. First electrode means including a plurality of separate electrode members each substantially cover top surfaces of the segments in each of said sections and electrically connect the segments in each of said sections. Second electrode means are formed on the exposed surface of said second semiconductor region and third electrode means are provided on the second major surface of the substrate. In this semiconductor device compression means electrically connected to said first and second electrode means apply pressure between said first electrode means and said third electrode means to thereby maintain said semiconductor device in a compressed state.

It is an object of the invention to provide a compression-type semiconductor device containing a semiconductor element which has a semiconductor region divided into a plurality of portions and which is maintained in a compressed state, in which the divided portions of the semiconductor region have planar shapes most desirable for optimally operating the element and which permits ready detection of defective portions.

Another object of the invention is to provide a semiconductor element which can be suitably used for the compression-type semiconductor device mentioned above.

The present invention provides a compression-type semiconductor device comprising: a semiconductor element comprising: a semiconductor substrate having first and second major surfaces, a first semiconductor region including a plurality of semiconductor sections, said sections each being composed of a plurality of semiconductor segments of a first conductivity type projecting from the first major surface of said substrate, said segments being arranged so that long sides of adjacent segments face each other, a second semiconductor region of a second conductivity type opposite to said first conductivity type formed in the first major surface and surrounding each of said semiconductor segments, first electrode means including a plurality of separate electrode members each substantially covering top surfaces of the segments in each of said sections and electrically connecting the segments in each of said sections, second electrode means formed on the exposed surface of said second semiconductor region, third electrode means formed on said second major surface of the substrate, and compression means for applying pressure between said first electrode means and said third electrode means to thereby maintain said semiconductor element in a compressed state, said compression means being electrically connected to said first and second electrode means, said compression-type semiconductor device being characterized in that said segments each have a substantially rectangular top surface, the segments in each of said sections have substantially the same size and are arranged so that the long sides of adjacent rectangular surfaces thereof face each other, and insulating means cover said second electrode means between the adjacent segments in each of said sections.

The present invention also provides a semiconductor element comprising a semiconductor substrate having first and second major surfaces, a first semiconductor region including a plurality of semiconductor sections, said sections each being composed of a plurality of semiconductor segments of a first conductivity type projecting from the first major surface of said substrate, said segments being arranged so that long sides of adjacent segments face each other, a second semiconductor region of a second conductivity type opposite to said first conductivity type formed in the first major surface and surrounding each of said semiconductor segments, first electrode means including a plurality of separate electrode members each substantially entirely covering top surfaces of the segments in each of said sections and electrically connecting the segments in each of said sections, second electrode means formed on the exposed surface of said second semiconductor region, and third electrode means formed on said second major surface of the substrate, said semiconductor element being characterized in that said segments each have a substantially rectangular top surface, the segments in each of said sections have substantially the same size and are arranged so that the long sides of adjacent rectangular surfaces thereof face each other, and insulating means cover said second electrode means between the adjacent segments in each of said sections.

According to the invention, a compression-type semiconductor device which comprises a semiconductor element and compression means for maintaining the semiconductor element in a compressed state is provided. The semiconductor element comprises a semiconductor substrate having first and second major surfaces. The semiconductor substrate has a first semiconductor region including a plurality of semiconductor sections. Each semiconductor section is composed of a plurality of divided semiconductor segments of a first conductivity type projecting on the first major surface of the substrate. These segments have substantially rectangular top surfaces which are present in a plane. The segments in each semiconductor section have approximately the same size and are arranged so that the long sides of adjacent rectangles face each other.

A second semiconductor region of a second conductivity type opposite to the first conductivity type is formed in the first major surface of the substrate, surrounding the individual semiconductor segments.

On the first semiconductor region first electrode means including separate electrode members is formed. The separate electrode members each substantially cover the top surfaces of the segments in each of the semiconductor sections, and electrically connect these segments. Second electrode means is formed on the exposed surface of the second semiconductor region. Third electrode means is formed on the second major surface of the semiconductor substrate.

Insulation means covers the second electrode means between the adjacent semiconductor segments in each semiconductor section.

According to the invention, the semiconductor segments (or mesa portions) constituting the semiconductor region of the first conductivity type formed in the semiconductor substrate are grouped into a plurality of sections each composed of a plurality of segments, and the segments in each section are connected with each other by the common electrode member. Thus, unlike the prior art, the operation of detecting defective element units need not be done for each of separate electrodes formed on each of segments, but may be done for each section, thus facilitating the operation and the mass production of the element if the number of the segments is increased. Therefore, it is possible to reduce the size of the first conductivity type segment for reducing the distance from the second semiconductor region, thus increasing the maximum controllable current $I_{ATO}$.

Since the portions defined between adjacent semiconductor segments in each semiconductor section are filled with the insulator, the first and second semiconductor regions or electrodes formed thereon will not be short-circuited if their exposed surfaces are pressed by the compression means. Therefore, there is no problem in reducing the sizes of the element units which each have the semiconductor segment.

The individual segments or element units in each section of the first semiconductor region have the same size and shape in this invention. When turning off the element unit, excess carrier is drained from the gate (or base). If the individual semiconductor segments have different shapes and sizes, different amounts of carriers are discharged, that is, the period required for the discharge of carriers (i.e., turn-off period) varies with the individual element units. Where the segments having different shapes and sizes are arranged in a single section and connected with one another by a common electrode, those segments which have different turn-off periods are operated together, and current is concentrated on units of longer turn-off periods, thus reducing the breakdown current value of the entire element. Where the segments in each section have the same shape and size as according to the invention, this problem does not occur.

With the semiconductor element according to the invention, the exposed top surfaces of the segments in each section are substantially covered by the common electrode. Generally, a power switching element generates a great amount of heat during its operation. In order to readily discharge the generated heat to the outside, it is necessary to reduce the thermal resistance of both anode (or collector) and cathode (or emitter). Generally, the thermal resistance is inversely proportional to the area of contact between the element and an envelope thereof having a metal post. From this viewpoint, it is desirable for the common electrode to substantially cover each exposed top surface of the segments in each section as according to the invention.

Furthermore, according to the invention, the segments in each section have a rectangular top surface and are arranged so that the long sides of the adjacent rectangles face each other. In other words, in each section the common electrode has a width approximately equal to the length of the segments and a length in the direction perpendicular to the long side of the rectangle. It is, therefore, possible to increase the ratio of the width to the length. Thus, the resistance of the electrode can be reduced, lowering the voltage drop across the electrode in the conductive state thereof so that it is possible to provide a substantially uniform operating condition to the individual element units in each section.

Thus, the semiconductor device according to the invention has superior switching characteristics and hence increased maximum controllable current and reduced turn-off period. It is also most suitable in mass production.

This invention can be more fully understood from the following detailed description when taken in conjunction with the accompanying drawings, in which:

Fig. 1 is a cross-sectional view showing a prior art compression-type GTO semiconductor device;

Fig. 2 is a cross-sectional view showing a compression-type semiconductor device having a GTO thyristor as a semiconductor element according to one embodiment of the invention; and

Fig. 3 is a partial view schematically showing a plan of the semiconductor element according to the invention.

The invention will be described in detail with reference to Figs. 2 and 3. In the figures, like parts are designated by like reference numerals.

As shown in Fig. 2, a compression-type GTO device according to one embodiment of the invention includes as a semiconductor element a GTO thyristor having an npnp four-layer silicon substrate 21. The substrate 21 has an n-type uppermost region which constitutes a cathode region. This region is divided into a plurality of mesa segments 22 which project on one major surface 21a of the substrate 21.

As is best shown in Fig. 3, the segments 22 have approximately rectangular top surfaces and are approximately the same size. The top surfaces of the segments lie in a plane. These segments 22 have a rectangular flat surface, with, for example, a length of 500 µm and a width of 100 µm. Their surface impurity concentration is $3 \times 10^{20}$ cm$^{-3}$, and the depth of the n-type region from the top surface is 10 µm. These segments are arranged approximately parallel to one another so that the long sides of the adjacent rectangular surfaces thereof face each other. Actually, 8,000 to 10,000 such segments are formed on the major surface 21a of the substrate 21.

Turning back to Fig. 2, the substrate 21 includes a p-type gate region 23 which forms a p-n junction with the cathode region and surrounds the mesa segments 22. The region 23 is exposed at the major surface 21a, and, as an example, has an impurity concentration of $3 \times 10^{17}$ cm$^{-3}$ and a thickness of 40 µm.

The substrate 21 further includes an n-type base region 24 underlying the gate region 23 and forming a p-n junction therewith. For example, the base region 24 has an impurity concentration of $4 \times 10^{13}$ cm$^{-3}$ and a thickness of 350 µm.

A p-type anode region 25 underlies the base region 24 and forms a p-n junction therewith. This anode region 25 is exposed at the other major surface 21b of the substrate 21. For example, the region 25 has a surface impurity concentration of $1 \times 10^8$ cm$^{-3}$ and a thickness of 50 µm.

Separate cathode electrode pieces 26 are formed to substantially cover the entire exposed top surface of each segment 22. As shown in Fig. 3, a plurality of segments 22 arranged in the direction perpendicular to the long side of the rectangular surfaces thereof are grouped as a section (while in the figure, each section is shown to include five segments for the sake of the simplicity, actually 100 segments, for instance, are included). Separate rectangular common cathode electrodes 27 are formed integrally with the electrode pieces 26 of the segments 22 in each section and substantially cover the section.

As shown in Fig. 2, gate electrodes 28 are formed on the exposed surface portion of the gate region 23 and an anode electrode 29 is mounted on the entire exposed surface 21b of the anode region 25.

In each section of the cathode region, the spaces defined by the sides of the segments 22, the sides of the electrode pieces 26 and the lower surface of the common electrode 27 are filled with an insulator 30 of material such as polyimide or poly(organofluoride), covering the gate electrodes 28. The insulator 30 serves to prevent a short-circuit between the cathode electrodes 26 and 27 and the gate electrode 28.

The peripheral side surfaces of the substrate 21 are covered with an insulator 31 of material such as silicone rubber, glass, or epoxy resin.

A metal plate 33 entirely covers the common electrodes 27, and a cylindrical metal post 35 presses the metal plate 33 against the common electrodes 27. A metal plate 34 is bonded to the anode electrode 29 at one surface thereof, and is supported by a metal post 36 at the other surface thereof. Thus, the GTO thyristor is maintained in a compressed state. A metal wire 32 is bonded to the gate electrode 28 at one end thereof, and is connected to a gate terminal of a housing of the device (not shown) at the other end thereof.

The conductivity of the GTO thyristor device of the above construction is the same as that of the prior art GTO thyristor device. At the same time, the switching characteristic is improved; in particular, the maximum controllable anode current $I_{ATO}$ is increased to about twice the value obtainable in the prior art device and the turn-off time is reduced to about one-third. Furthermore, with the construction of the invention the detection of a defective element unit or units can be readily achieved. For example, if 10,000 element units having the segments 22 are formed in the substrate and each group of 100 segments 22 is connected by the common electrode 27, only 100 (10,000/100) operations for detection are required at maximum. In order to detect defective element units in the prior art construction having the same number of units, 10,000 operations for detection are required.

As described above, each common electrode 27 covers the segments in each section which lie approximately parallel to each other in the direction perpendicular to the long sides of the rectangular top surfaces thereof. If a common cathode electrode lies in a direction perpendicular to the short sides of the rectangular surfaces of the segments, it will have a very short width and an extremely long length. In this case, therefore, not only the number of element units that can be connected to one another is limited by the diameter of the substrate, but also, if the pressure applied by a compression means is not uniform, a considerable voltage drop on the electrode results at the time of the conduction. It is thus no longer possible to provide uniform operating conditions to the individual element units. When connecting the common cathode electrode 27 as according to the invention, if there are 100 element units, for example, each having a nearly rectangular surface with a length of 1 mm and a width of 50 μm, the shape of the common cathode electrode 27 is also rectangular with dimensions of about 1 cm by 1 mm. If the thickness of the common cathode electrode is 5 μm, the resistance in the length direction is 0.04 Ω, in the case of using Al as the common electrode. On the other hand, where the common cathode electrode lies in the direction perpendicular to the short sides of the rectangular surfaces of the element units, with the other conditions being the same as above, the common cathode electrode has a shape with dimensions of 10.5 cm by 50 μm, and the resistance in the length direction is as high as 8.4 Ω.

To manufacture the GTO thyristor as described above, the p-type region 25, n-type region 24, p-type region 23 and n-type region as the uppermost layer are successively formed in the mentioned order in the silicon substrate 21 by the ordinary diffusion method. A mask is then formed on the surface of the uppermost n-type region, and the substrate is selectively etched to form grooves reaching the p-type region 23 and leave predetermined portions of the uppermost n-type region. In this way, n-type mesa segments 22 are formed. The p-n junction formed by the mesa segments 22 and p-type region 23 is then passivated with $SiO_2$, phosphosilicate glass, etc. Al or like metal is then vapor-deposited on the surface of the substrate, and the deposited layer thus formed is then selectively photoetched to form the gate electrodes 28 and cathode electrode pieces 26. The insulator 30 consisting of polyimide, poly (organofluoride) or the like is next formed to cover the electrodes 26 and 28 and is then removed to the extent necessary to expose the cathode electrode pieces 26. In this case, it is preferable that the surface of the insulator layer 30 on the gate electrodes 28 is flush with the surface of the electrode pieces 26. If there is a step between these surfaces, breakage of the common cathode electrode 27 which is subsequently formed as the second layer is liable, and in such a case the construction according to the invention can not be realized. In addition, if such a step is present, the pressure applied to the cathode segments 22 is increased, resulting in the generation of pressure distribution. Thereafter, the common cathode electrodes 27 are formed to connect the exposed electrode pieces 26 of the cathode segments 26 by depositing and photoetching a metal layer.

The embodiment as described above is by no means limitative, and the invention is also applicable to other semiconductor devices having a forced contact type electrode structure including a region of a first conductivity type consisting of divisions formed on one surface of a semiconductor substrate and a region of a second conductivity type surrounding the first conductivity type region. One example is a power transistor with the emitter constituted by the first conductivity type region and the base constituted by the second conductivity type region, which is capable of carrying a collector current in excess of 100 A. While in the above embodiment the cathode segments have all been of the same size, it is only necessary that the segments 22 in each section are of the same size. Segments in different sections may have different sizes. Furthermore, while in the above embodiment the electrode pieces 26 and the common electrodes are separately formed, the common electrodes may have protrusions integral therewith corresponding to the electrode pieces 26, and the common electrodes may be bonded to the segment surfaces at their protrusions. Furthermore, the cathode electrode pieces 26 may be omitted, and the common cathode electrode 27 may directly cover the top surfaces of the segments in each section.

## Claims

1. A compression-type semiconductor device comprising:

(a) a semiconductor element comprising:

a semiconductor substrate (21) having first and second major surfaces,

a first semiconductor region including a plurality of semiconductor sections, said sections each being composed of a plurality of semiconductor segments (22) of a first conductivity type projecting from the first major surface of said substrate (21), said segments (22) being arranged so that long sides of adjacent segments (22) face each other,

a second semiconductor region (23) of a second conductivity type opposite to said first conductivity type formed in the first major surface and surrounding each of said semiconductor segments (22),

first electrode means (27) including a plurality of separate electrode members each substantially covering top surfaces of the segments (22) in each of said sections and electrically connecting the segments (22) in each of said sections,

second electrode means (28) formed on the exposed surface of said second semiconductor region,

third electrode means (29) formed on said second major surface of the substrate (21), and

(b) compression means (35) for applying pressure between said first electrode means (27) and said third electrode means (29) to thereby maintain said semiconductor element in a compressed state, said compression means (35) being electrically connected to said first and second electrode means (27, 28),

characterized in that

said segments (22) each have a substantially rectangular top surface, the segments (22) in each of said sections have substantially the same size and are arranged so that the long sides of adjacent rectangular surfaces thereof face each other, and

insulating means (30) cover said second electrode means (28) between the adjacent segments (22) in each of said sections.

2. The semiconductor device according to claim 1, characterized in that said first electrode means (27) includes separate electrode pieces (26) each formed on the top surface of each of said semiconductor segments (22), said first electrode means (27) being connected to said electrode pieces (26).

3. The semiconductor device according to claim 1, characterized in that said semiconductor element is a gate turn-off thyristor with a cathode region thereof constituted by said first semiconductor region and a gate region thereof constituted by said second semiconductor region (23).

4. The semiconductor device according to claim 3, characterized in that said semiconductor substrate (21) further includes a third semiconductor region (24) forming a p-n junction with said second semiconductor region (23) and a fourth semiconductor region (25) forming a p-n junction with said third semiconductor region (24) and reaching said second major surface of said substrate (21).

5. The semiconductor device according to claim 1, characterized in that said semiconductor element is a transistor with an emitter region thereof constituted by said first semiconductor region and a base region thereof constituted by said second semiconductor region (23).

6. The semiconductor device according to claim 2, characterized in that said insulating means (30) has a surface flush with the top surfaces of said electrode pieces (26).

7. A semiconductor element comprising:

a semiconductor substrate (21) having first and second major surfaces,

a first semiconductor region including a plurality of semiconductor sections, said sections each being composed of a plurality of semiconductor segments (22) of a first conductivity type projecting from the first major surface of said substrate (21), said segments (22) being arranged so that long sides of adjacent segments (22) face each other,

a second semiconductor region (23) of a second conductivity type opposite to said first conductivity type formed in the first major surface and surrounding each of said semiconductor segments (22),

first electrode means (27) including a plurality of separate electrode members each substantially entirely covering top surfaces of the segments (22) in each of said sections and electrically connecting the segments (22) in each of said sections,

second electrode means (28) formed on the exposed surface of said second semiconductor region, and

third electrode means (29) formed on said second major surface of the substrate (21),

characterized in that

said segments (22) each have a substantially rectangular top surface, the segments (22) in each of said sections have substantially the same size and are arranged so that the long sides of adjacent rectangular surfaces thereof face each other, and

insulating means (30) cover said second electrode means (28) between the adjacent segments (22) in each of said sections.

8. The semiconductor element according to claim 7, characterized in that said first electrode means (27) includes separate electrode pieces (26) each formed on the top surface of each of said semiconductor segments (22), said first electrode means (27) being connected to said electrode pieces (26).

9. The semiconductor element according to claim 7, characterized in that said semiconductor element is a gate turn-off thyristor with a cathode region thereof constituted by said first semiconductor region and a gate region thereof constituted by said second semiconductor region (23).

10. The semiconductor element according to claim 9, characterized in that said semiconductor substrate (21) further includes a third semiconductor region (24) forming a p-n junction with said second semiconductor region (23) and a fourth semiconductor region (25) forming a p-n junction with said third semiconductor region (24) and reaching said second major surface of said substrate (21).

11. The semiconductor element according to claim 7, characterized in that said semiconductor element is a transistor with an emitter region thereof constituted by said first semiconductor region and a base region thereof constituted by said second semiconductor region (23).

12. The semiconductor element according to claim 8, characterized in that said insulating means (30) has a surface flush with the top surfaces of said electrode pieces (26).

**Patentansprüche**

1. Kompressions-Halbleitervorrichtung, umfassend

(a) ein Halbleiterelement mit

einem eine erste und eine zweite Hauptfläche aufweisenden Halbleitersubstrat (21),

einer eine Anzahl von Halbleiterbereichen aufweisenden ersten Halbleiterzone, wobei die Bereiche jeweils durch eine Anzahl von Halbleitersegmenten (22) eines ersten Leitfähigkeitstyps gebildet sind, die von der ersten Hauptfläche des Substrats hochragen, wobei die Segmente (22) so angeordnet sind, daß die Langseiten benachbarter Segmente (22) einander zugewandt sind,

einer zweiten Halbleiterzone (23) eines zweiten, dem ersten Leitfähigkeitstyp entgegengesetzten Leitfähigkeitstyps, die in der ersten Hauptfläche ausgebildet ist und jedes der Halbleitersegmente (22) umgibt oder umschließt,

einer ersten Elektrodeneinheit (27) mit einer Anzahl getrennter Elektrodenelemente, welche jeweils praktisch die Oberseiten der Segmente (22) in jedem Bereich bedecken und die Segmente (22) in jedem dieser Bereiche elektrisch verbinden,

einer auf der freiliegenden Fläche der zweiten Halbleiterzone ausgebildeten zweiten Elektrodeneinheit (28), (sowie)

einer auf der zweiten Hauptfläche des Substrats (21) ausgebildeten dritten Elektrodeneinheit (29) und

(b) eine Kompressionseinheit (35) zur Ausübung eines Drucks zwischen der ersten Elektrodeneinheit (27) und der dritten Elektrodeneinheit (29), um damit das Halbleiterelement in einem Kompressionszustand zu halten, wobei die Kompressionseinheit (35) mit erster und zweiter Elektrodeneinheit (27, 28) elektrisch verbunden ist,

dadurch gekennzeichnet, daß

die Segmente (22) jeweils eine im wesentlichen rechteckige Oberseite aufweisen, wobei die Segmente (22) in jedem der Bereiche im wesentlichen dieselbe Größe besitzen und so angeordnet sind, daß die Langseiten ihrer benachbarten rechteckigen Flächen einander zugewandt sind, und

Isoliereinheiten (30) die zweite Elektrodeneinheit (28) zwischen den benachbarten Segmenten (22) in jedem der Bereiche bedecken.

2. Halbleitervorrichtung nach Anspruch 1, dadurch gekennzeichnet, daß die erste Elektrodeneinheit (27) getrennte Elektrodenstücke oder -teile (26) aufweist, die jeweils auf der (den) Oberseite(n) jedes der Halbleitersegmente (22) ausgebildet sind, und die erste Elektrodeneinheit (27) mit den Elektrodenstücken (26) verbunden ist.

3. Halbleitervorrichtung nach Anspruch 1, dadurch gekennzeichnet, daß das Halbleiterelement ein Abschalt-Thyristor ist, dessen Kathodenzone durch die erste Halbleiterzone und dessen Gatezone durch die zweite Halbleiterzone (23) gebildet sind.

4. Halbleitervorrichtung nach Anspruch 3, dadurch gekennzeichnet, daß das Halbleitersubstrat (21) weiterhin eine einen p-n-Übergang mit der zweiten Halbleiterzone (23) bildende dritte Halbleiterzone (24) sowie eine einen p-n-Übergang mit der dritten Halbleiterzone (24) bildende und an die zweite Hauptfläche des Substrats (21) heranreichende vierte Halbleiterzone (25) aufweist.

5. Halbleitervorrichtung nach Anspruch 1, dadurch gekennzeichnet, daß das Halbleiterelement ein Transistor ist, dessen Emitterzone durch die erste Halbleiterzone und dessen Basiszone durch die zweite Halbleiterzone (23) gebildet sind.

6. Halbleitervorrichtung nach Anspruch 2, dadurch gekennzeichnet, daß die Isoliereinheit(en) (30) (je) eine mit den Oberseiten der Elektrodenstücke (26) bündig abschließende Fläche aufweist (aufweisen).

7. Halbleiterelement, umfassend

ein Halbleitersubstrat (21) mit einer ersten und einer zweiten Hauptfläche,

eine erste Halbleiterzone mit einer Anzahl von Halbleiterbereichen, die durch eine Anzahl von Halbleitersegmenten (22) eines ersten Leitfähigkeitstyps, die von der ersten Hauptfläche des Substrats (21) hochragen, gebildet sind, wobei die Segmente (22) so angeordnet sind, daß die Langseiten benachbarter Segmente (22) einander zugewandt sind,

eine in der ersten Hauptfläche ausgebildete und jedes der Halbleitersegmente (22) umgebende oder umschließende zweite Halbleiterzone (23) eines zweiten, dem ersten Leitfähigkeitstyp entgegengesetzten Leitfähigkeitstyps,

eine erste Elektrodeneinheit (27) mit einer Anzahl getrennter Elektrodenelemente, die jeweils praktisch vollständig die Oberseiten der Segmente (22) in jedem Bereich bedecken und die Segmente (22) in jedem dieser Bereiche elektrisch verbinden,

eine auf der freiliegenden Fläche der zweiten Halbleiterzone ausgebildete zweite Elektrodeneinheit (28) und

eine auf der zweiten Hauptfläche des Substrats (21) ausgebildete dritte Elektrodeneinheit (29),

dadurch gekennzeichnet, daß

die Segmente (22) jeweils eine im wesentlichen rechteckige Oberseite aufweisen, wobei die Segmente (22) in jedem der Bereiche jeweils im wesentlichen dieselbe Größe besitzen und so angeordnet sind, daß die Langseiten ihrer benachbarten rechteckigen Flächen einander zugewandt sind, und

Isoliereinheiten (30) die Elektrodeneinheit (28) zwischen benachbarten Segmenten (22) in jedem der Bereiche bedecken.

8. Halbleiterelement nach Anspruch 7, dadurch gekennzeichnet, daß die erste Elektrodeneinheit (27) getrennte Elektrodenstücke oder -teile (26) aufweist, die jeweils auf der (den) Oberseite(n) jedes der Halbleitersegmente (22) ausgebildet sind, und die erste Elektrodeneinheit (27) mit den Elektrodenstücken (26) verbunden ist.

9. Halbleiterelement nach Anspruch 7, dadurch gekennzeichnet, daß das Halbleiterelement ein Abschalt-Thyristor ist, dessen Kathodenzone durch die erste Halbleiterzone und dessen Gatezone durch die zweite Halbleiterzone (23) gebildet sind.

10. Halbleiterelement nach Anspruch 9, dadurch gekennzeichnet, daß das Halbleitersubstrat (21) weiterhin eine einen p-n-Übergang mit der zweiten Halbleiterzone (23) bildende dritte Halbleiterzone (24) sowie eine einen p-n-Übergang mit der dritten Halbleiterzone (24) bildende und an die zweite Hauptfläche des Substrats (21) heranreichende vierte Halbleiterzone (25) aufweist.

11. Halbleiterelement nach Anspruch 7, dadurch gekennzeichnet, daß das Halbleiterelement ein Transistor ist, dessen Emitterzone durch die erste Halbleiterzone und dessen Basiszone durch die zweite Halbleiterzone (23) gebildet sind.

12. Halbleiterelement nach Anspruch 8, dadurch gekennzeichnet, daß die Isoliereinheit(en) (30) (je) eine mit den Oberseiten der Elektrodenstücke (26) bündig abschließende Fläche aufweist (aufweisen).

**Revendications**

1. Un dispositif à semiconducteurs du type à compression comportant:

(a) un élément semiconducteur comprenant:

un substrat semiconducteur (21) présentant une première et une seconde surfaces principales,

une première région semiconductrice comprenant une pluralité de parties semiconductrices, lesdites parties étant composées chacune d'une pluralité de segments semiconducteurs (22) d'un premier type de conductivité faisant saillie par rapport à la première surface principale dudit substrat (21), lesdits segments (22) étant disposés de manière que les grands côtés de segments adjacents (22) soient situés l'un en face de l'autre,

une seconde région semiconductrice (23) d'un second type de conductivité opposé audit premier type de conductivité et formée dans la première surface principale et entourant chacun desdits segments semiconducteurs (22),

des premiers moyens à électrodes (27) comportant une pluralité d'éléments électrodes séparés recouvrant chacun sensiblement la surface supérieure des segments (22) dans chacune desdites parties et reliant électriquement les segments (22) dans chacune desdites parties,

des deuxièmes moyens à électrodes (28) formés sur la surface exposée de ladite seconde région semiconductrice,

des troisièmes moyens à électrodes (29) formés sur ladite seconde surface principale du substrat (21), et

(b) des moyens de compression (35) pour appliquer une pression entre lesdits premiers moyens à électrodes (27) et lesdits troisièmes moyens à électrodes (29) pour maintenir ainsi ledit élément semiconducteur à l'état comprimé, lesdits moyens de compression (35) étant reliés électriquement auxdits premiers et seconds moyens à électrodes (27, 28),

caractérisé en ce que

lesdits segments (22) présentent chacun une surface supérieure sensiblement rectangulaire, les segments (22) dans chacune desdites parties ont sensiblement la même taille et sont disposés de manière que les grands côtés de leurs surfaces rectangulaires adjacentes soient situés l'un en face de l'autre, et

des moyens d'isolation (30) recouvrent lesdits seconds moyens à électrodes (28) entre les segments adjacents (22) dans chacune desdites parties.

2. Le dispositif à semiconducteurs selon la revendication 1, caractérisé en ce que lesdits premiers moyens à électrodes (27) comportent des pièces électrodes séparées (26) formées chacune sur la surface supérieure de chacun desdits segments semiconducteurs (22), lesdits premiers moyens à électrodes (27) étant reliés auxdites pièces électrodes (26).

3. Le dispositif à semiconducteurs selon la revendication 1, caractérisé en ce que ledit élément semiconducteur est un thyristor porte de coupure dont une région de cathode est constituée par ladite première région semiconductrice et dont une région de porte est constituée par ladite seconde région semiconductrice (23).

4. Le dispositif à semiconducteurs selon la revendication 3, caractérisé en ce que ledit substrat semiconducteur (21) comporte de plus une troisième région semiconductrice (24) formant une jonction p-n avec ladite seconde région semiconductrice (23) et une quatrième région semiconductrice (25) formant une jonction p-n avec ladite troisième région semiconductrice (24) et atteignant ladite seconde surface principale dudit substrat (21).

5. Le dispositif à semiconducteurs selon la revendication 1, caractérisé en ce que ledit élément semiconducteur est un transistor dont une région d'émetteur est constituée par ladite première région semiconductrice et dont une région de base est constituée par ladite seconde région semiconductrice (23).

6. Le dispositif à semiconducteurs selon la revendication 2, caractérisé en ce que lesdits moyens d'isolation (30) présentent une surface de niveau avec les surfaces supérieures desdites pièces électrodes (26).

7. Un élément semiconducteur comportant:

un substrat semiconducteur (21) comprenant une première et une seconde surfaces principales,

une première région semiconductrice comportant une pluralité de parties semiconductrices, lesdits parties étant chacune composées d'une pluralité de segments semiconducteurs (22) d'un premier type de conductivité faisant saillie de la première surface principale dudit substrat (21), lesdits segments (22) étant disposés de manière que les grands côtés de segments adjacents (22) soient situés l'un en face de l'autre,

une seconde région semiconductrice (23) d'un second type de conductivité opposé audit premier type de conductivité et formée dans la première surface principale et entourant chacun desdits segments semiconducteurs (22),

des premiers moyens à électrodes (27) comportant une pluralité d'éléments électrodes séparés recouvrant chacun sensiblement toute la surface supérieure des segments (22) dans chacune desdites parties et reliant électriquement les segments (22) dans chacune desdites parties,

des seconds moyens à électrodes (28) formés sur la surface exposée de ladite seconde région semiconductrice, et

des troisièmes moyens à électrodes (29) formés sur ladite seconde surface principale du substrat (21),

caractérisé en ce que

lesdits segments (22) présentent chacun une surface supérieure sensiblement rectangulaire, les segments (22) dans chacune desdites parties ont sensiblement la même taille et sont disposés de manière que les grands côtés de leurs surfaces rectangulaires adjacentes soient situés l'un en face de l'autre, et

des moyens d'isolation (30) recouvrent lesdits seconds moyens à électrodes (28) entre les segments adjacents (22) dans chacune desdites parties.

8. L'élément semiconducteur selon la revendication 7, caractérisé en ce que lesdits premiers moyens à électrodes (27) comportent des pièces électrodes séparées (26) formées chacune sur la surface supérieure de chacun desdits segments semiconducteurs (22), lesdits premiers moyens à électrodes (27) étant reliés auxdites pièces électrodes (26).

9. L'élément semiconducteur selon la revendication 7, caractérisé en ce que ledit élément semiconducteur est un thyristor porte de coupure dont une région de cathode est constituée par ladite première région semiconductrice et dont une région de porte est constituée par ladite seconde région semiconductrice (23).

10. L'élément semiconducteur selon la revendication 9, caractérisé en ce que ledit substrat semiconducteur (21) comporte de plus une troisième région semiconductrice (24) formant une jonction p-n avec ladite seconde région semiconductrice (23) et une quatrième région semiconductrice (25) formant une jonction p-n avec ladite troisième région semiconductrice (24) et atteignant ladite seconde surface principale dudit substrat (21).

11. L'élément semiconducteur selon la revendication 7, caractérisé en ce que ledit élément semiconducteur est un transistor dont une région d'émetteur est constituée par ladite première région semiconductrice et dont une région de base est constituée par ladite seconde région semiconductrice (23).

12. L'élément semiconducteur selon la revendication 8, caractérisé en ce que lesdits moyens d'isolation (30) présentent une surface de niveau avec les surfaces supérieures desdites pièces électrodes (26).

# F I G. 1

# F I G. 2

# F I G. 3

1